# EUROPÄISCHE PATENTSCHRIFT

(11) **EP 1 530 805 B1**
(45) Veröffentlichungstag und Bekanntmachung des Hinweises auf die Patenterteilung: **20.08.2008**
(21) Anmeldenummer: 03740028.0
(22) Anmeldetag: 23.05.2003
(51) Int. Cl.: H01L 41/083, H01L 41/047

(54) **PIEZOAKTOR**
PIEZOELECTRIC ACTUATOR
ACTIONNEUR PIEZOELECTRIQUE

(30) Priorität: 13.08.2002 DE 10236986
(43) Veröffentlichungstag der Anmeldung: 18.05.2005
(73) Patentinhaber: ROBERT BOSCH GMBH, 70442 Stuttgart (DE)
(72) Erfinder: ENDRISS, Axel, 70378 Stuttgart (DE)
(86) Internationale Anmeldenummer: PCT/DE2003/001678
(87) Internationale Veröffentlichungsnummer: WO 2004/019423

(56) Entgegenhaltungen:
- WO-A-00/57497
- WO-A-01/22503
- PATENT ABSTRACTS OF JAPAN vol. 2002, no. 10, 10. Oktober 2002 (2002-10-10) -& JP 2002 171003 A (KYOCERA CORP), 14. Juni 2002 (2002-06-14)

## Beschreibung

### Stand der Technik

Die Erfindung betrifft einen Piezoaktor, beispielsweise zur Betätigung eines mechanischen Bauteils, wie ein Schaltventile bei Kraftstoffeinspritzsystemen in Kraftfahrzeugen oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses sogenannten Piezoaktors kann hier in mehreren Schichten erfolgen (Multilayer- oder Vielschicht-Aktoren), wobei die Elektroden, über die die elektrische Spannung aufgebracht wird, jeweils zwischen den Schichten angeordnet werden.

Die äußere elektrische Kontaktierung der Innenelektroden eines solchen Vielschicht-Piezoaktors erfolgt in der Regel über eine elektrisch leitende Verbindung auf der seitlichen Oberfläche des Aktors. Diese Verbindung kann vollflächig, strukturiert oder auch streifenförmig verwirklicht werden. Im einfachsten Fall handelt es sich dabei um eine galvanisch aufgebrachte Schicht, eine zunächst aufgedruckte und anschließend eingebrannte Schicht, z.B. Leitsilberpaste, oder auch um eine aufgeklebte Schicht eines elektrisch leitenden Polymers. Diese Schicht kann unmittelbar kontaktiert werden, indem z.B. ein Kabel angelötet wird.

Im Hinblick auf die Dauerhaltbarkeit werden jedoch auch häufig mehrschichtige Elektrodenstrukturen verwendet. Dabei dient die bereits beschriebene Galvanik-, Einbrennoder Polymerschicht lediglich als Grundmetallisierung. Das heißt sie dient zur elektrisch leitenden Verbindung zu den Elektrodenschichten im Inneren des Piezoaktors, sowie auch als Haftvermittler für die darauf aufgebrachte nächste Schicht, an welcher der Piezoaktor nach Außen kontaktiert wird. Um dem Versagen durch die ständige mechanische Wechselbelastung bei Betrieb, als auch durch Unterschiede in der thermischen Ausdehnung der beteiligten Materialien vorzubeugen, wird versucht, die auf die Grundmetallisierung aufgebrachte Schicht möglichst flexibel zu gestalten.

Aus der DE 199 28 190 A1 ist ein solcher Außenelektrodenaufbau für einen Piezoaktor bekannt, bei dem eine netzoder gewebeartige Elektrode auf der eigentlichen Außenelektrode aufgebracht ist. Es sind weiterhin, beispielsweise aus der DE 199 17 728 A1, auch Lösungen in Form vieler, einzeln angelöteter Drähte, einem aufgelöteten wellenförmigen Metallstreifen, einem aufgelöteten gefalteten Sieb aus Invar oder einem aufgeklebten elektrisch leitenden Polymer, in welchem beispielsweise ein Draht eingelassen ist, an sich bekannt.

Die bekannten Elektrodenaufbauten haben den Nachteil, dass diese technologisch sehr aufwendig sind; d.h. es müssen beispielsweise oft viele Drähte einzeln angelötet werden, oder es muss zunächst eine Stegelektrode elektrochemisch abgeschieden werden. Diese Lösungen können oft nur unter einer Reihe von Randbedingungen tatsächlich funktionieren, z.B. ist die gefaltete Siebelektrode nur dehnungstolerant wenn die Siebmaschen nicht mit Lot gefüllt sind und sie funktioniert konzeptionell auch nur wenn es gilt, flächig zu kontaktieren. Das Konzept der punktuellen Auflage greift z.B. nicht im Falle einer erforderlichen streifenförmigen Kontaktierungsfläche. Kritisch im Falle einer punktuellen Kontaktierung mit vielen Einzeldrähten ist insbesondere auch das Handling des fertig kontaktierten Piezoaktors. Aufgrund des sich dabei ergebenden komplizierten Aufbaus sind hier deutliche Einschränkungen im Design der Umgebung als auch hohe Anforderungen an das Montagekonzept zu erwarten.

Aus der JP 2002-171003 A ist bereits ein Piezoaktor bekannt, der einen üblichen Mehrschichtaufbau von keramischen Piezolagen und dazwischen angeordneten Innenelektroden aufweist. Eine wechselseitige seitliche Kontaktierung der Innenelektroden erfolgt über Außenelektroden, über die eine elektrische Spannung zuführbar ist. Ein erster Teil des Außenelektrodenaufbaus wird durch eine leitende Fläche auf jeweils einer Seitenfläche, die mit den jeweiligen Innenelektroden kontaktiert ist, gebildet. Ein zweiter Teil des Außenelektrodenaufbaus ist als eine flexible Außenelektrode auf dem ersten Teil angeordnet, wobei die flexible Außenelektrode zumindest punktweise mit dem ersten Teil kontaktiert ist. Die zweite flexible Außenelektrode ist in Form einer wendelförmigen Außenelektrode ausgebildet, bei der einzelne Windungen der Wendel punktförmig mit der leitenden Fläche als erster Teil der Außenelektrode kontaktiert sind.

### Vorteile der Erfindung

Der eingangs beschriebene Piezoaktor, der beispielsweise zur Betätigung eines mechanischen Bauteils verwendbar sein kann, weist einen Mehrschichtaufbau von keramischen Piezolagen und dazwischen angeordneten Innenelektroden auf, bei denen mit einer wechselseitigen seitlichen Kontaktierung über Außenelektroden eine elektrische Spannung zuführbar ist. Ein erster Teil des Außenelektrodenaufbaus ist eine leitende Fläche, z.B. eine Lotschicht, auf jeweils einer Seitenfläche, die mit den jeweiligen Innenelektroden kontaktiert ist und ein zweiter Teil des Außenelektrodenaufbaus ist gattungsgemäß als eine flexible Außenelektrode auf diesem Teil angeordnet, wobei die flexible Außenelektrode mit dem ersten Teil kontaktiert ist und wobei zwischen den Kontaktierungen dehnbare Bereiche zu liegen kommen.

Erfindungsgemäß ist die zweite flexible Außenelektrode in vorteilhafter Weise eine wendelförmige Außenelektrode, bei der einzelne Windungen der Wendel punkt- oder flächenförmig mit der leitenden Fläche als erstem Teil der Außenelektrode kontaktiert sind. Auberdem befindet sich die eine oder auch mehrere neben- oder aneinanderliegende Wendel auf einem nichtleitenden Stab, der auch als Distanzstück mit einer in etwa der Wendel angepassten Geometrie wirkt. Die Wendel kann dabei auf einfache Weise aus einem gewickelten Draht mit einer aufgetragenen Lotschicht gebildet sein, wobei der Draht beispielsweise aus FeNi36 und die Lotschicht aus einem Zinn-Blei- oder Zinn-Silber-Lot gebildet ist.

Die hier vorgeschlagene wendelförmige Außenelektrode verbindet somit die Vorteile der punktuellen Kontaktierung mit einzelnen Drähten, die eine hohe Dehnungstoleranz und einen sicheren elektrischen Kontakt auch bei einem Riss in der Grundmetallisierung als leitende Fläche aufweist, mit denen einer gefalteten Siebelektrode. Hier ist ein einfaches Handling des fertig kontaktierten Piezoaktors erreicht ohne dabei die Nachteile der bekannten Anordnungen zu übernehmen.

Insbesondere ist damit auch die sichere Kontaktierung eines schmalen Streifens als leitende Fläche der Außenelektrode möglich. Gegenüber einer bekannten gefalteten Siebelektrode ergibt sich weiterhin der Vorteil, dass kein Versteifungseffekt durch mit Lot gefüllte Maschen möglich ist. Verglichen mit der gefalteten Siebelektrode ist die hier vorgeschlagene Kontaktierung daher weitaus dehnungstoleranter. Auch der Überbrückungseffekt im Falle eines Risses in der Grundmetallisierung ist wesentlich sicherer gegeben.

Zur Herstellung der Kontaktierung wird der in der Art einer Wendel gewickelte Draht, beispielsweise bestehend aus einem Material wie Invar, auf die Grundmetallisierung aufgelötet. Diese Drahtwendel hat dabei nur auf einer Seite punktuellen Kontakt mit der Grundmetallisierung. Kommt es in Folge der in der Regel auftretenden mechanischen Wechselbelastung zu einem Riss der Grundmetallisierung, so gewährleistet die erfindungsgemäße Wendel eine sichere elektrische Überbruckung.

Alternativ kann die Wendel auch mittels einer geklebten oder eingebrannten Verbindung auf der leitenden Fläche als erstem Teil der Außenelektrode kontaktiert sein, wobei z.B. die Kontaktierung mittels eines elektrisch leitenden Polymers oder einer Einbrennpaste, vorzugsweise eine Leitsilberpaste, vorgenommen ist. Ferner kann an die jeweilige Wendel auch ein Drahtstift zur Kontaktierung der Außenelektrode angebracht sein.

### Zeichnung

Ausführungsbeispiele des erfindungsgemäßen Piezoaktors werden anhand der Zeichnung erläutert. Es zeigen:
Figur 1 einen Schnitt durch einen Piezoaktor mit einem Mehrschichtaufbau von Lagen aus Piezokeramik und Innenelektroden sowie einer kontaktierten Wendel als Außenelektrode auf einer ersten flächigen Außenelektrode,
Figuren 2a bis 2f sechs Schnitte durch mögliche Ausführungsformen der Wendelgeometrie,
Figur 3 eine schematische Seitenansicht eines Piezoaktors mit mehreren Wendeln als Außenelektroden,
Figur 4 eine Ansicht eines Ausführungsbeispiels, das in Abwandlung der Darstellung nach der Figur 1 einen zusätzlichen Drahtstift zur Kontaktierung aufweist und
Figur 5 einen Schnitt durch die Wendel nach der Figur 4.

### Beschreibung der Ausführungsbeispiele

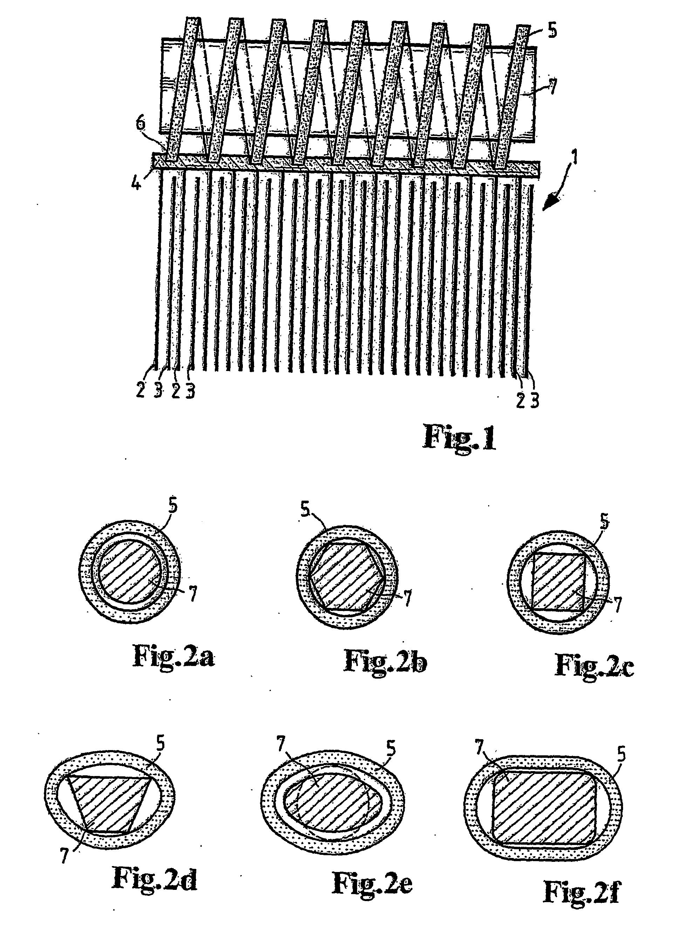

In Figur 1 ist ein Piezoaktor 1 gezeigt, der in an sich bekannter Weise aus Piezofolien eines Keramikmaterials mit einer geeigneten Kristallstruktur aufgebaut ist, so dass unter Ausnutzung des sogenannten Piezoeffekts bei Anlage einer äußeren elektrischen Spannung an Innenelektroden 2 und 3 eine mechanische Reaktion des Piezoaktors 1 erfolgt.

Mit den Innenelektroden 2 steht hier eine Grundmetallisierung als erster flächiger Teil 4 einer Außenelektrode in Kontakt, die wiederum mit einer Wendel als zweiter flexibler Teil 5 der Außenelektrode über Punktkontakte 6, beispielsweise durch Löten, Leitkleben, Schweißen oder Einbrennen kontaktiert ist. Als Basis für die Außenelektrode dient hier somit ein zu einer Wendel 5 gewickelter Draht, vorzugsweise bestehend aus FeNi36, welcher beispielsweise galvanisch mit Zinn-Blei- oder Zinn-Silber-Lot vorbelotet ist. Alternativ zu einer vorbeloteten Wendel 5 kann auch eine nicht vorbelotete Drahtwendel verwendet werden. Das Lotdepot ist in diesem Fall in Form einer Lötbahn, einer Lötpaste oder einer Lotfolie vorab auf die Grundmetallisierung 4 zu bringen.

Zum Auflöten auf die Grundmetallisierung 4 des Aktors 1 wird die Wendel 5 auf einen Stab 7, bestehend aus einem gegen die beim Löten auftretenden Temperaturen beständigen Material, beispielsweise Teflon, gesteckt, damit die Wendel 5 gut an den Aktor 1 angedrückt werden kann ohne dabei zusammengedrückt zu werden.

Die Wendel 5 mit dem als Distanzstück dienenden Stab 7 im Inneren wird mit einer definierten Kraft in einer Lötform lagerichtig auf die zu kontaktierende Fläche 4 des Aktors 1 gedrückt. Anschließend kann die Wendel im sogenannten Reflow-Verfahren, vorzugsweise in einer Dampfphase, auf den Aktor 1 gelötet werden. Die Kontaktierung des Aktors 1 erfolgt dann durch Anlöten oder Anschweißen eines hier in der Figur 1 nicht dargestellten Anschlussdrahtes an der Außenseite der Wendel 5.

Die Geometrie der Wendel 5 hinsichtlich des Drahtdurchmessers, der Steigung und des Wendeldurchmessers ist dabei an die Geometrie des Aktors 1, bzw. dessen Innenaufbau, insbesondere des Schichtabstand anzupassen. Mögliche Alternativen der Geometrie der Wendel 5 und des Stabes 7 sind in Figuren 2a bis 2f gezeigt. Die Wendel 5 und der Stab 7 ist gemäß der Darstellung links oben der Figur 2a rund; möglich sind aber auch beliebige eckige Varianten der Figuren 2b bis 2d oder in bestimmten Fällen, z.B. im Falle einer flächigen Kontaktierung, sind ev. andere ovale oder flachgedrückte Geometrien, wie in Figur 2e und 2f recht unten gezeigt, sinnvoll. Der Querschnitt und die Form des als Distanzstück dienenden Stabs 7 ist in allen diesen Fällen der Geometrie der Wendel 5 entsprechend anzupassen.

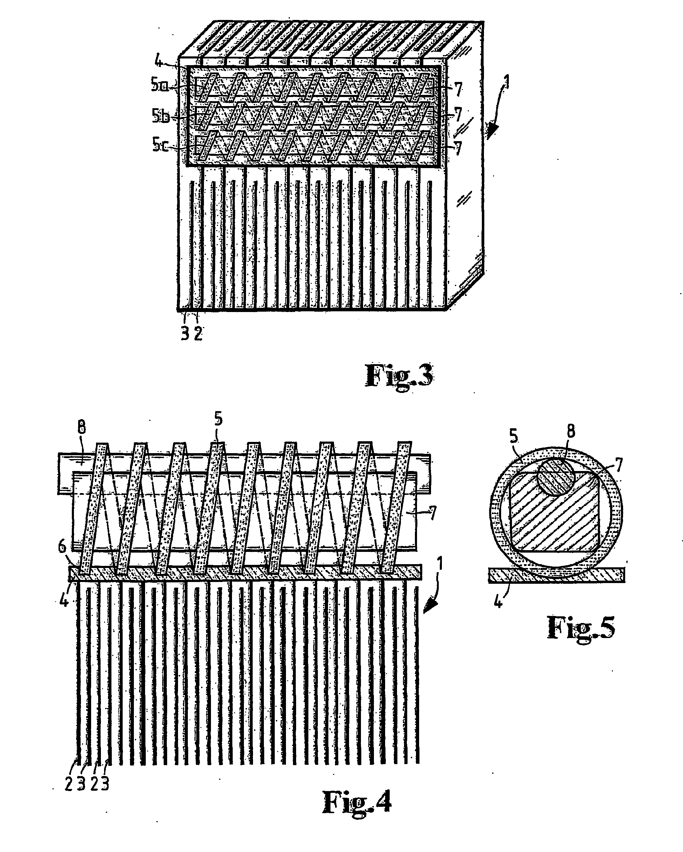

Nach Figur 3 sind mehrere Drahtwendeln 5a, 5b und 5c nebeneinander angeordnet und in Figur 4 und 5 ist ein Ausführungsbeispiel gezeigt, bei dem an die Drahtwendel 5 vor dem Vorbeloten ein Stift 8, entweder durchgehend oder auch nur als kurzes Anschlussstück, angeschweißt ist, welcher später zur Kontaktierung des Piezoaktors 1 verwendet wird.

## Patentansprüche

1. Piezoaktor mit
- einem Mehrschichtaufbau von keramischen Piezolagen und dazwischen angeordneten Innenelektroden (2, 3),
- einer wechselseitigen seitlichen Kontaktierung der Innenelektroden (2, 3) über Außenelektroden (4, 5), über die eine elektrische Spannung zuführbar ist, wobei
- als ein erster Teil (4) des Außenelektrodenaufbaus (4, 5) eine leitende Fläche auf jeweils einer Seitenfläche angebracht ist, die mit den jeweiligen Innenelektroden (2,3) kontaktiert ist und ein zweiter Teil (5) des Außenelektrodenaufbaus (4, 5) als eine flexible Außenelektrode (5) auf dem ersten Teil (4) angeordnet ist, wobei die flexible Außenelektrode (5) zumindest punktweise mit dem ersten Teil (4) kontaktiert ist und wobei zwischen den Kontaktierungen (6) dehnbare Bereiche zu liegen kommen, und
- die zweite flexible Außenelektrode eine wendelförmige Außenelektrode (5) ist, bei der einzelne Windungen der Wendel (5; 5a, 5b, 5c) punkt- oder flächenförmig mit der leitenden Fläche (4) als erster Teil der Außenelektrode (4, 5) kontaktiert sind,
**dadurch gekennzeichnet, dass**
sich die Wendel (5; 5a, 5b, 5c) auf einem Stab (7) mit einer der Wendel (5; 5a, 5b, 5c) im wesentlichen angepassten Geometrie befindet.

2. Piezoaktor nach Anspruch 1,
**dadurch gekennzeichnet, dass**
die Wendel (5; 5a, 5b, 5c) aus einem gewickelten Draht mit einer aufgetragenen Lotschicht gebildet ist.

3. Piezoaktor nach Anspruch 2,
**dadurch gekennzeichnet, dass**
der Draht aus FeNi36 und die Lotschicht aus einem Zinn-Blei- oder Zinn-Silber-Lot gebildet ist.

4. Piezoaktor nach Anspruch 1,
**dadurch gekennzeichnet, dass**
die Wendel (5; 5a, 5b, 5c) mittels einer geklebten oder eingebrannten Verbindung auf der leitenden Fläche (4) als erster Teil der Außenelektrode (4, 5) kontaktiert ist.

5. Piezoaktor nach Anspruch 2,
**dadurch gekennzeichnet, dass**
die Kontaktierung (6) mittels eines elektrisch leitenden Polymers oder einer Einbrennpaste, vorzugsweise einer Leitsilberpaste, vorgenommen ist.

6. Piezoaktor nach Anspruch 1,
**dadurch gekennzeichnet, dass**
die leitende Fläche (4) als erster Teil der Außenelektrode (4, 5) eine Lotschicht ist.

7. Piezoaktor nach einem der vorhergehenden Ansprüche,
**dadurch gekennzeichnet, dass** mehrere Wendeln (5; 5a, 5b, 5c) nebeneinander angeordnet sind.

8. Piezoaktor nach einem der vorhergehenden Ansprüche,
**dadurch gekennzeichnet, dass**
an die jeweilige Wendel (5; 5a, 5b, 5c) ein Drahtstift (8) zur Kontaktierung der Außenelektrode (4, 5) angebracht ist.

## Claims

1. Piezoelectric actuator having
- a multiple-layer structure of ceramic piezoelectric layers and inner electrodes (2, 3) which are arranged between them,
- alternate-side lateral contact of the inner electrodes (2, 3) via outer electrodes (4, 5), via which an electrical voltage can be supplied,
- a conductive surface being applied as first part (4) of the outer electrode structure (4, 5) to in each case one side surface which makes contact with the respective inner electrodes (2, 3), and a second part (5) of the outer electrode structure (4, 5) being arranged as a flexible outer electrode (5) on the first part (4), the flexible outer electrode (5) making contact with the first part (4) at least in a punctiform manner and expandable regions coming to lie between the contacts (6), and
- the second flexible outer electrode being a helical outer electrode (5), in which individual windings of the helix (5; 5a, 5b, 5c) make punctiform or full-surface contact with the conductive surface (4) as first part of the outer electrode (4, 5),
**characterized in that** the helix (5; 5a, 5b, 5c) is situated on a rod (7) having a geometry which is adapted substantially to the helix (5; 5a, 5b, 5c).

2. Piezoelectric actuator according to Claim 1, **characterized in that** the helix (5; 5a, 5b, 5c) is formed from a wound wire having an applied solder layer.

3. Piezoelectric actuator according to Claim 2, **characterized in that** the wire is formed from FeNi36 and the solder layer is formed from a tin/lead or a tin/silver solder.

4. Piezoelectric actuator according to Claim 1, **characterized in that** the helix (5; 5a, 5b, 5c) has contact made with it by means of an adhesively bonded or stoved connection on the conductive surface (4) as first part of the outer electrode (4, 5).

5. Piezoelectric actuator according to Claim 2, **characterized in that** the contact (6) is made by means of an electrically conductive polymer or a stoving paste, preferably a conductive silver paste.

6. Piezoelectric actuator according to Claim 1, **characterized in that** the conductive surface (4) as first part of the outer electrode (4, 5) is a solder layer.

7. Piezoelectric actuator according to one of the preceding claims, **characterized in that** a plurality of helixes (5; 5a, 5b, 5c) are arranged next to one another.

8. Piezoelectric actuator according to one of the preceding claims, **characterized in that** a wire pin (8) is attached to the respective helix (5; 5a, 5b, 5c) for making contact with the outer electrode (4, 5).

## Revendications

1. Actionneur piézo-électrique comportant :
- une structure à plusieurs couches formée de couches piézoélectriques céramiques et entre celles-ci des électrodes intérieures (2, 3),
- une mise en contact latéral sur le côté alterné des électrodes intérieures (2, 3) par des électrodes extérieures (4, 5) pour appliquer une tension électrique, et
- comme première partie (4) de la structure d'électrodes extérieures (4, 5), on applique une surface conductrice chaque fois sur une surface latérale en contact avec les électrodes intérieures respectives (2, 3), et une seconde partie (5) de la structure d'électrodes extérieures (4, 5) est appliquée comme électrode extérieure souple (5) sur la première partie (4),
- l'électrode extérieure souple (5) étant en contact au moins ponctuellement avec la première partie (4), et
- des zones extensibles, entre les contacts (6), et
- la seconde électrode extérieure souple est une électrode extérieure en forme d'hélice et les différentes spires de l'hélice (5, 5a, 5b, 5c) touchent par un contact ponctuel ou de surface, la surface conductrice (4) comme première partie de l'électrode extérieure (4, 5),
**caractérisé en ce que**
les spires (5, 5a, 5b, 5c) se trouvent sur une tige (7) de géométrie essentiellement adaptée à la spire (5, 5a, 5b, 5c).

2. Actionneur piézo-électrique selon la revendication 1,
**caractérisé en ce que**
les spires (5, 5a, 5b, 5c) sont formées d'un fil enroulé muni d'une couche de brasure.

3. Actionneur piézo-électrique selon la revendication 2,
**caractérisé en ce que**
le fil est en FeNi (36) et la couche de brasure est une couche de brasure étain-plomb ou étain-argent.

4. Actionneur piézo-électrique selon la revendication 1,
**caractérisé en ce que**
la spire (5, 5a, 5b, 5c) est mise en contact par une liaison collée ou cuite avec la surface conductrice (4) constituant la première partie de l'électrode extérieure (4, 5).

5. Actionneur piézo-électrique selon la revendication 2,
**caractérisé en ce que**
le contact (6) est réalisé par un polymère électroconducteur ou par une pâte cuite notamment une pâte conductrice en argent.

6. Actionneur piézo-électrique selon la revendication 1,
**caractérisé en ce que**
la surface conductrice (4) est une couche de soudure constituant la première partie de l'électrode extérieure (4, 5).

7. Actionneur piézo-électrique selon l'une quelconque des revendications précédentes,
**caractérisé par**
plusieurs spires (5, 5a, 5b, 5c) juxtaposées.

8. Actionneur piézo-électrique selon l'une quelconque des revendications précédentes,
**caractérisé en ce que**
chaque spire (5, 5a, 5b, 5c) porte une broche de fil (8) pour réaliser le contact de l'électrode extérieure (4, 5).
